# EUROPÄISCHE PATENTSCHRIFT

(11) **EP 3 556 190 B1**
(45) Veröffentlichungstag und Bekanntmachung des Hinweises auf die Patenterteilung: **22.02.2023**
(21) Anmeldenummer: 17823081.9
(22) Anmeldetag: 14.12.2017
(51) Int. Cl.: H05K 7/14, H05K 7/18

(54) **ANORDNUNG VON TRAGELEMENTEN ELEKTRONISCHER MODULE**
ASSEMBLY OF CARRIERS FOR ELECTRONIC MODULES
DISPOSITIF DE SUPPORT POUR MODULES ÉLECTRONIQUES

(30) Priorität: 16.12.2016 DE 102016124637
(43) Veröffentlichungstag der Anmeldung: 23.10.2019
(73) Patentinhaber: Phoenix Contact GmbH & Co KG, 32825 Blomberg (DE)
(72) Erfinder: HELLMANN, Klas, 31787 Hameln (DE)
(74) Vertreter: Patentship Patentanwaltsgesellschaft mbH
(86) Internationale Anmeldenummer: PCT/EP2017/082925
(87) Internationale Veröffentlichungsnummer: WO 2018/109124

(56) Entgegenhaltungen:
- EP-A1- 0 661 915
- EP-A1- 1 251 595
- EP-A1- 3 104 237
- DE-U1- 20 310 761
- US-A1- 2009 023 320
- US-A1- 2015 214 657
- Pilz GmbH & Co. KG: "PSSuniversal - Programmable control systems PSS - System Description - No. 21256-EN-04", , 2. Januar 2010 (2010-01-02), Seiten 1-89, XP055041267, Gefunden im Internet: URL:http://www.pilz.com/downloads/open/PSS universal_Sys_Descr_21256-EN-04.pdf [gefunden am 2012-10-17]

## Beschreibung

Die vorliegende Erfindung betrifft eine Anordnung von Tragelementen gemäß den Ansprüchen 1-14.

In elektronischen Anwendungen müssen oftmals eine hohe Zahl, bzw. unterschiedliche Funktionen an einem Ort realisiert werden, so dass modular aufgebaute elektronische Systeme verwendet werden. Bei der Installation von modular aufgebauten elektronischen Systemen, werden verschiedene elektronische Funktionsmodule verwendet, welche mechanisch und elektrisch miteinander verbunden sind. Die elektrische Verbindung der elektronischen Funktionsmodule umfasst insbesondere Steckkontakte, elektrische Kabel und/oder Kontaktbrücken. Die mechanische Verbindung der elektronischen Funktionsmodule stellt eine wirksame und direkte Verbindung der elektronischen Funktionsmodule sicher. Bei Systemen mit verschiedenen elektronischen Funktionsmodulen müssen im Vergleich zu einzelnen elektronischen Funktionsmodulen oftmals sehr kostenaufwendige und technisch aufwendige mechanische und elektrische Verbindungen verwendet werden.

Die Druckschrift US 2015/214657 A1 betrifft ein Verbindungssystem für Geräte, insbesondere Sicherheitsschaltgeräte, im Bereich der industriellen Automatisierungstechnik.

Die Druckschrift US 2009/023320 A1 offenbart ein modulares elektrisches Bussystem.

Es ist die Erfindung zugrundeliegende Aufgabe, eine wirksame und mit geringem Aufwand bereitzustellende mechanische und elektrische Verbindung zwischen verschiedenen elektronischen Funktionsmodulen sicherzustellen.

Diese Aufgabe wird durch Gegenstände mit Merkmalen nach den unabhängigen Ansprüchen gelöst. Vorteilhafte Ausführungsformen der Erfindung sind Gegenstand der Figuren, der Beschreibung und der abhängigen Ansprüche.

Gemäß einem ersten Aspekt der Erfindung wird die Aufgabe durch eine Anordnung von Tragelementen zur Halterung von elektronischen Funktionsmodulen gelöst, mit einem ersten Tragelement, wobei das erste Tragelement eine Oberseite und eine Unterseite aufweist, wobei in der Oberseite eine erste Stegaufnahme gebildet ist, und wobei in der Unterseite eine zweite Stegaufnahme gebildet ist, und einem zweiten Tragelement, wobei das zweite Tragelement einen ersten Seitensteg und einen zweiten Seitensteg aufweist, wobei der erste Seitensteg in die erste Stegaufnahme einführbar ist, und wobei der zweite Seitensteg in die zweite Stegaufnahme einführbar ist.

Dadurch wird der Vorteil erreicht, dass eine besonders wirksame und einfach bereitzustellende mechanische Verbindung zwischen dem ersten und zweiten Tragelement ermöglicht wird. Durch die wirksame mechanische Verbindung zwischen dem ersten und zweiten Tragelement können auch die durch die jeweiligen Tragelemente gehaltenen elektronischen Funktionsmodule wirksam miteinander mechanisch verbunden werden.

In herkömmlichen elektronischen Geräten, werden elektronische Funktionsmodule mit hoher Schutzart, z.B. größer als IP44, einzeln in einer Maschine oder Anlage montiert. Wenn mehrere elektronische Funktionsmodule in unmittelbarer Nähe zueinander angeordnet sind, werden diese z.B. mit einer entsprechenden Montageplatte zu einer Einheit verbaut. Der elektrische Anschluss der elektronischen Funktionsmodule an die umliegenden Geräte erfolgt beispielsweise durch elektrische Steckverbindungen.

In der erfindungsgemäßen Anordnung werden die beiden Tragelemente durch das Einführen der beiden Seitenstege in die jeweiligen Stegaufnahmen wirksam miteinander mechanisch verbunden. Durch die Aneinanderreihung von zwei oder mehreren Tragelementen kann eine ausreichend mechanisch stabile Basis bereitgestellt werden, auf der zumindest ein elektronisches Funktionsmodul gehalten werden kann und gemeinsam mit weiteren elektronischen Funktionsmodulen einen festen mechanischen Verbund eingehen können, ohne eine Montageplatte verwenden zu müssen. Somit stellen die erfindungsgemäßen Tragelemente eine wirksame und mit geringem Aufwand bereitzustellende mechanische und elektrische Verbindung zwischen verschiedenen elektronischen Funktionsmodulen sicher.

In einer vorteilhaften Ausführungsform der Anordnung bilden das erste Tragelement und das zweite Tragelement eine selbstragende Anordnung von Tragelementen, insbesondere eine selbsttragende und befestigbare Anordnung, und/oder sind das erste Tragelement und das zweite Tragelement auf einer Tragschiene, insbesondere einer Hutschiene, verschiebbar befestigbar.

Dadurch wird der Vorteil erreicht, dass eine selbsttragende, insbesondere eine selbsttragende und befestigbare, Anordnung von Tragelementen, eine wirksame und stabile Befestigung der Anordnung an einem Bauteil ermöglicht. Durch die Verwendung einer Hutschiene, bzw. Profilschiene, wird eine wirksame verschiebbare Befestigung der miteinander verbundenen Tragelemente an der Hutschiene ermöglicht, wobei die Hutschiene wiederum an einem Bauteil befestigbar ist.

In einer vorteilhaften Ausführungsform der Anordnung von Tragelementen weist das erste Tragelement eine Tragelementbreite auf, wobei die erste Stegaufnahme und die zweite Stegaufnahme als Vertiefungen mit einer Vertiefungsbreite geformt sind, welche geringer als die Tragelementbreite ist.

Dadurch wird der Vorteil erreicht, dass die sich abschnittsweise über die gesamte Tragelementbreite erstreckende und als Vertiefung ausgebildete Stegaufnahmen ein wirksames Aufnehmen des jeweiligen Seitenstegs sicherstellen, wodurch eine mechanisch stabile Verbindung zwischen den Tragelementen bereitgestellt werden kann.

In einer weiteren vorteilhaften Ausführungsform der Anordnung von Tragelementen weist das zweite Tragelement eine Oberseite und eine Unterseite auf, wobei der erste Seitensteg in der Oberseite des zweiten Tragelements gebildet ist, oder wobei der zweite Seitensteg in der Unterseite des zweiten Tragelements gebildet ist.

Dadurch wird der Vorteil erreicht, dass das Anordnen des ersten und zweiten Seitenstegs auf unterschiedlichen Seiten des zweiten Tragelements eine wirksame mechanische Befestigung zwischen dem ersten und zweiten Tragelement sicherstellt. Der an der Oberseite des zweiten Tragelements gebildete erste Seitensteg und der an der Unterseite des zweiten Tragelements gebildete zweite Seitensteg werden in die entsprechenden ersten und zweiten Stegaufnahmen des ersten Tragelements eingeführt. Hierbei beaufschlagen der erste und zweite Seitensteg die jeweilige erste und zweite Stegaufnahme beidseitig mit einer Kraft und befestigen damit das erste Tragelement wirksam an dem zweiten Tragelement.

In einer weiteren vorteilhaften Ausführungsform der Anordnung von Tragelementen ist in der Oberseite des ersten Tragelements eine erster Seitensteg gebildet, welcher in eine erste Stegaufnahme eines weiteren Tragelements einführbar ist, und ist in der Unterseite des ersten Tragelements eine zweiter Seitensteg gebildet, welcher in eine zweite Stegaufnahme des weiteren Tragelements einführbar ist.

Dadurch wird der Vorteil erreicht, dass der erste und zweite Seitensteg des ersten Tragelements ermöglichen, dass das erste Tragelement wirksam mit einem weiteren Tragelement verbunden wird. Das weitere Tragelement kann ebenfalls erste und zweite Seitenstege aufweisen, so dass eine Verbindung des ersten Tragelements mit mehreren weiteren Tragelementen möglich ist, wodurch die Anordnung von Tragelementen ausreichend erweitert werden kann, um eine Vielzahl von elektronischen Funktionsmodulen zu halten.

In einer weiteren vorteilhaften Ausführungsform der Anordnung von Tragelementen ist in einer Oberseite des zweiten Tragelements eine erste Stegaufnahme zur Aufnahme eines ersten Seitenstegs eines dritten Tragelements gebildet, und ist in einer Unterseite des zweiten Tragelements eine zweite Stegaufnahme zur Aufnahme eines zweiten Seitenstegs des dritten Tragelements gebildet.

Dadurch wird der Vorteil erreicht, dass die erste und zweite Stegaufnahme des zweiten Tragelements ermöglichen, dass das zweite Tragelement wirksam mit einem dritten Tragelement verbunden wird. Das dritte Tragelement kann ebenfalls erste und zweite Stegaufnahmen aufweisen, so dass eine Verbindung des dritten Tragelements mit mehreren zusätzlichen Tragelementen möglich ist, wodurch die Anordnung von Tragelementen ausreichend erweitert werden kann, um eine Vielzahl von elektronischen Funktionsmodulen zu halten.

In einer weiteren vorteilhaften Ausführungsform der Anordnung von Tragelementen ist in einer Unterseite des ersten, zweiten, dritten und/oder weiteren Tragelements jeweils eine dritte Stegaufnahme gebildet, und weist das erste, zweite und/oder dritte Tragelement jeweils einen dritten Seitensteg auf, wobei der dritte Seitensteg des ersten Tragelements in die dritte Stegaufnahme des weiteren Tragelements einführbar ist, wobei der dritte Seitensteg des zweiten Tragelements in die dritte Stegaufnahme des ersten Tragelements einführbar ist, und/oder wobei der dritte Seitensteg des dritten Tragelements in die dritte Stegaufnahme des zweiten Tragelements einführbar ist.

Dadurch wird der Vorteil erreicht, dass durch das Einführen des ersten, zweiten und dritten Seitenstegs in die entsprechenden ersten, zweiten und dritten Stegaufnahmen eine stabilere mechanische Befestigung der Tragelemente miteinander gewährleistet werden kann, als wenn nur zwei Seitenstege und zwei Stegaufnahmen verwendet werden.

In einer weiteren vorteilhaften Ausführungsform der Anordnung von Tragelementen sind der erste Seitensteg und die erste Stegaufnahme, der zweite Seitensteg und die zweite Stegaufnahme, und/oder der dritte Seitensteg und die dritte Stegaufnahme nebeneinander in dem ersten, zweiten und/oder dritten Tragelement angeordnet.

Dadurch wird der Vorteil erreicht, dass durch die Nebeneinanderanordnung des jeweiligen Seitenstegs und der jeweiligen Stegaufnahme sichergestellt ist, dass sich die jeweiligen Seitenstege und Stegaufnahme auf den unterschiedlichen Tragelementen in gleicher Höhe angeordnet sind. Dadurch lassen sich die Seitenstege in die entsprechenden Stegaufnahmen eines jeweils benachbarten Tragelements wirksam einführen.

In einer weiteren vorteilhaften Ausführungsform der Anordnung von Tragelementen ist der erste, zweite und/oder dritte Seitensteg jeweils durch eine Rastverbindung in der jeweiligen ersten, zweiten und/oder dritten Stegaufnahme befestigbar.

Dadurch wird der Vorteil erreicht, dass eine Rastverbindung eine wirksame Befestigung der Tragelemente untereinander sicherstellt, welche nicht unbeabsichtigt gelöst werden kann.

In einer weiteren vorteilhaften Ausführungsform der Anordnung von Tragelementen weisen der erste, zweite und/oder dritte Seitensteg jeweils eine Befestigungsöffnung zur Aufnahme eines Befestigungselements auf, und weisen die erste, zweite oder dritte Stegaufnahme jeweils eine weitere Befestigungsöffnung zur Aufnahme des Befestigungselements auf.

Dadurch wird der Vorteil erreicht, dass durch Aufnahme des Befestigungselements in den Befestigungsöffnungen und in den weiteren Befestigungsöffnungen eine stabile Befestigung der Anordnung von Tragelementen ermöglicht wird. Bei miteinander verbundenen Tragelementen liegen die jeweiligen Befestigungsöffnungen auf gleicher Höhe der entsprechenden weiteren Befestigungsöffnungen, so dass das entsprechende Befestigungselement wirksam in der jeweiligen Befestigungsöffnung, bzw. weiteren Befestigungsöffnung aufgenommen werden kann.

In einer weiteren vorteilhaften Ausführungsform der Anordnung von Tragelementen umfasst das Befestigungselement eine Schraube zum Verbinden des ersten, zweiten, dritten und/oder weiteren Tragelements miteinander, oder umfasst einen Bolzen eines elektronischen Funktionsmoduls zum Befestigen des elektronischen Funktionsmoduls an dem ersten, zweiten, dritten und/oder weiteren Tragelement.

Dadurch wird der Vorteil erreicht, dass eine Schraube eine Befestigung der verschiedenen Tragelemente miteinander, bzw. ein Bolzen eine Befestigung des elektronischen Funktionsmoduls an dem entsprechenden Tragelement ermöglicht. Es können auch verschiedene Befestigungsöffnungen und verschiedene weitere Befestigungsöffnungen zur Befestigung der Tragelemente miteinander verwendet werden oder es können elektronische Funktionsmodule an dem entsprechenden Tragelement befestigt werden.

In einer weiteren vorteilhaften Ausführungsform der Anordnung von Tragelementen ist in einer Oberseite des ersten, zweiten, dritten und/oder weiteren Tragelements eine erste Kabelaufnahme zur Aufnahme eines ersten elektrischen Kabels und/oder eine zweite Kabelaufnahme zur Aufnahme eines zweiten elektrischen Kabels gebildet.

Dadurch wird der Vorteil erreicht, dass durch die Kabelaufnahmen zur Aufnahme der jeweiligen elektrischen Kabel sichergestellt wird, dass eine wirksame elektrische Verbindung zwischen den elektronischen Funktionsmodulen innerhalb der Anordnung von Tragelementen sichergestellt wird.

Gemäß einem zweiten Aspekt der Erfindung wird die Aufgabe durch ein Komponentenaufbausystem gelöst, mit einer Anordnung aus zumindest einem ersten und zweiten Tragelement nach dem ersten Aspekt; einem ersten elektrischen Kabel, welches in einer ersten Kabelaufnahme an einer Oberseite des zumindest einen ersten und zweiten Tragelements aufgenommen ist; einem zweiten elektrischen Kabel, welches in einer zweiten Kabelaufnahme an einer Oberseite des zumindest einen ersten und zweiten Tragelements aufgenommen ist; und zumindest einem ersten elektronischen Funktionsmodul zum Aufsetzen auf das erste und zweite Tragelement, wobei das erste elektronische Funktionsmodul mit dem ersten elektrischen Kabel und mit dem zweiten elektrischen Kabel elektrisch leitend verbunden ist.

Dadurch wird der Vorteil erreicht, dass das Komponentenaufbausystem eine besondere kompakte und einfach zu montierende Anordnung von einer Anzahl von elektronischen Funktionsmodulen ermöglicht. Hier stellt die vorteilhafte Verbindung der Tragelemente sicher, dass eine wirksame Basis zum Aufsetzen von einem oder mehreren elektronischen Funktionsmodulen gewährleistet ist. Die elektronischen Funktionsmodule sind somit wirksam mechanisch fixiert und durch die elektrischen Kabel ebenfalls wirksam miteinander elektrisch verbunden.

In einer vorteilhaften Ausführungsform des Komponentenaufbausystems weist das erste elektronische Funktionsmodul an einer Unterseite ein Befestigungselement auf, um das erste elektronische Funktionsmodul an dem ersten und zweiten Tragelement zu befestigen.

Dadurch wird der Vorteil erreicht, dass durch das Befestigungselement, insbesondere Bolzen, ein wirksames Positionieren und Befestigen des ersten elektronischen Funktionsmodul an dem ersten und zweiten Tragelement sichergestellt wird.

In einer vorteilhaften Ausführungsform des Komponentenaufbausystems umfassen das erste und zweite elektrische Kabel jeweils eine Isolationsschicht und zumindest eine elektrische Leiterbahn, wobei das erste elektronische Funktionsmodul eine elektrisch leitfähige Dornanordnung zum Durchstechen der jeweiligen Isolationsschicht und zum elektrischen Kontaktieren der jeweiligen elektrischen Leiterbahn umfasst.

Dadurch wird der Vorteil erreicht, dass durch das Aufsetzten des ersten elektronischen Funktionsmoduls auf das erste und zweite elektrische Kabel durch das Durchstechen der jeweiligen Isolationsschicht mittels der elektrisch leitfähigen Dornanordnung eine wirksame elektrisch leitende Verbindung zwischen dem ersten und zweiten elektrischen Kabel und dem ersten elektronischen Funktionsmodul bereitgestellt wird. Ausführungsbeispiele der Erfindung sind in den Zeichnungen dargestellt und werden im Folgenden näher beschrieben.

Es zeigen:
- Fig. 1: eine schematische Ansicht einer Anordnung von Tragelementen gemäß einer Ausführungsform;
- Fig. 2: eine schematische Ansicht einer Anordnung von Tragelementen mit elektrischen Kabeln gemäß einer zweiten Ausführungsform;
- Fig. 3: eine schematische Ansicht eines elektronischen Komponentenaufbausystems mit einer Anordnung von Tragelementen, elektrischen Kabeln und einem elektronischen Funktionsmodul gemäß einer dritten Ausführungsform; und
- Fig. 4: eine schematische Ansicht eines elektronischen Komponentenaufbausystems gemäß der dritten Ausführungsform.

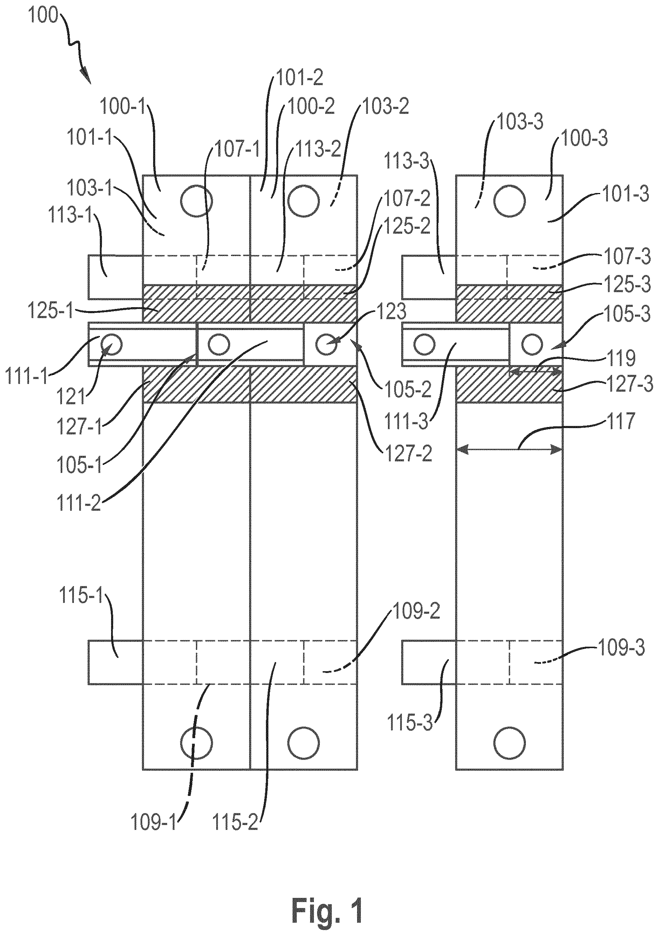

Fig. 1 zeigt eine schematische Ansicht einer Anordnung von Tragelementen gemäß einer Ausführungsform. Die Anordnung von Tragelementen 100 umfasst ein erstes Tragelement 100-1, ein zweites Tragelement 100-2 und ein drittes Tragelement 100-3. Das erste, zweite und dritte Tragelement 100-1, 100-2 und 100-3 können eine selbstragende, insbesondere selbsttragende und befestigbare, Anordnung bilden oder können auf einer Tragschiene, bzw. Profilschiene, verschiebbar befestigbar sein.

Das erste, zweite und dritte Tragelement 100-1, 100-2 und 100-3 sind ausgebildet elektronische Funktionsmodule zu halten, wobei die elektronischen Funktionsmodule insbesondere elektronische Automatisierungsgeräte umfassen. Das erste, zweite und dritte Tragelement 100-1, 100-2 und 100-3 können mit einer beliebigen Anzahl von weiteren Tragelementen 100-x verbunden werden, um eine Tragelementverbund zu bilden, welcher den modularen Aufbau von unterschiedlichen elektronischen Funktionsmodulen ermöglicht.

Das erste, zweite und dritte Tragelement 100-1, 100-2 und 100-3 weisen jeweils eine Oberseite 101-1, 101-2, 101-3 und weisen jeweils eine Unterseite 103-1, 103-2, 103-3 auf.

An der Oberseite 101-1, 101-2, 101-3 des ersten, zweiten und dritten Tragelements 100-1, 100-2, 100-3 ist jeweils eine erste Stegaufnahme 105-1, 105-2, 105-3 gebildet. An der Unterseite 103-1, 103-2, 103-3 des ersten, zweiten und dritten Tragelements 100-1, 100-2, 100-3 ist jeweils eine zweite Stegaufnahme 107-1, 107-2, 107-3 gebildet. Ferner ist an der Unterseite 103-1, 103-2, 103-3 des ersten, zweiten und dritten Tragelements 100-1, 100-2, 100-3 jeweils eine dritte Stegaufnahme 109-1, 109-2, 109-3 gebildet.

Da die zweiten Stegaufnahmen 107-1, 107-2, 107-3 und dritten Stegaufnahmen 109-1, 109-2, 109-3 an der jeweiligen Unterseite 103-1, 103-2, 103-3 des ersten, zweiten und dritten Tragelements 100-1, 100-2, 100-3 gebildet sind, sind diese in Fig. 1 nur schematisch angedeutet.

Das erste, zweite und dritte Tragelement 100-1, 100-2 und 100-3 weisen an der jeweiligen Oberseite 101-1, 101-2, 101-3 jeweils einen ersten Seitensteg 111-1, 111-2, 111-3 auf. Der erste Seitensteg 111-2 des zweiten Tragelements 100-2 ist in die erste Stegaufnahme 105-1 des ersten Tragelements 100-1 seitlich einführbar. Der erste Seitensteg 111-3 des dritten Tragelements 100-3 ist in die erste Stegaufnahme 105-2 des zweiten Tragelements 100-2 seitlich einführbar. Der erste Seitensteg 111-1 des ersten Tragelements 100-1 ist in die erste Stegaufnahme 105-x eines in Fig. 1 nicht dargestellten weiteren Tragelements 100-x seitlich einführbar.

Das erste, zweite und dritte Tragelement 100-1, 100-2 und 100-3 weisen an der jeweiligen Unterseite 103-1, 103-2, 103-3 jeweils einen zweiten Seitensteg 113-1, 113-2, 113-3 und jeweils einen dritten Seitensteg 115-1, 115-2, 115-3 auf.

Der zweite Seitensteg 113-2 des zweiten Tragelements 100-2 ist in die zweite Stegaufnahme 107-1 des ersten Tragelements 100-1 seitlich einführbar. Der zweite Seitensteg 113-3 des dritten Tragelements 100-3 ist in die zweite Stegaufnahme 107-2 des zweiten Tragelements 100-2 seitlich einführbar. Der zweite Seitensteg 113-1 des ersten Tragelements 100-1 ist in eine zweite Stegaufnahme 107-x eines in Fig. 1 nicht dargestellten weiteren Tragelements 100-x seitlich einführbar.

Der dritte Seitensteg 115-2 des zweiten Tragelements 100-2 ist in die dritte Stegaufnahme 109-1 des ersten Tragelements 100-1 seitlich einführbar. Der dritte Seitensteg 115-3 des dritten Tragelements 100-3 ist in die dritte Stegaufnahme 109-2 des zweiten Tragelements 100-2 seitlich einführbar. Der dritte Seitensteg 113-1 des ersten Tragelements 100-1 ist in eine dritte Stegaufnahme 109-x eines in Fig. 1 nicht dargestellten weiteren Tragelements 100-x seitlich einführbar.

Durch das Einführen der jeweiligen Seitenstege 111-1, 111-2, 111-3, 113-1, 113-2, 113-3, 115-1, 115-2, 115-3, in die entsprechenden Stegaufnahmen 105-1, 105-2, 105-3, 105-x, 107-1, 107-2, 107-3, 107-x, 109-1, 109-2, 109-3, 109-x kann eine wirksame Verbindung und damit stabile seitliche Befestigung des ersten, zweiten, dritten und weiteren Tragelements 100-1, 100-2, 100-3, 100-x miteinander sichergestellt werden. Dadurch können die Tragelemente 100-1, 100-2, 100-3, 100-x einen wirksamen Tragelementverbund bilden, welcher auf entweder selbsttragend ist oder auf einer Tragschiene verschiebbar befestigbar ist. Die Befestigung der jeweiligen Seitenstege 111-1, 111-2, 111-3, 113-1, 113-2, 113-3, 115-1, 115-2, 115-3 in den entsprechenden Stegaufnahmen 105-1, 105-2, 105-3, 105-x, 107-1, 107-2, 107-3, 107-x, 109-1, 109-2, 109-3, 109-x kann durch eine Rastverbindung sichergestellt werden. Es wird betont, dass sowohl das erste Tragelement 100-1, als auch das dritte Tragelement 100-3, jeweils mit einer beliebigen Anzahl an weiteren Tragelementen 100-x, bzw. zusätzlichen Tragelementen, seitlich verbunden werden kann, um einen den Anforderungen entsprechenden ausgedehnten Tragelementverbund zu bilden.

In dem in Fig. 1 dargestellten Ausführungsbeispiel weisen das erste, zweite, dritte, und weitere Tragelement 100-1, 100-2, 100-3 jeweils erste, zweite und dritte Seitenstege 111-1, 111-2, 111-3, 113-1, 113-2, 113-3, 115-1, 115-2, 115-3 auf. Dennoch kann es ausreichend sein, wenn das erste, zweite, dritte, bzw. weitere Tragelement 100-1, 100-2, 100-3, 100-x nur zwei Seitenstege und zwei Stegaufnahmen aufweist, bzw. es ist alternativ auch möglich, dass das erste, zweite, dritte, bzw. weitere Tragelement 100-1, 100-2, 100-3, 100-x vier oder mehr Seitenstege und vier oder mehr Stegaufnahmen aufweist.

Wie in der Fig. 1 dargestellt ist, sind der erste Seitensteg 111-1, 111-2, 111-3 und die jeweilige erste Stegaufnahme 105-1, 105-2, 105-3, sind der zweite Seitensteg 113-1, 113-2, 113-3 und die jeweilige zweite Stegaufnahme 107-1, 107-2, 107-3, und sind der dritte Seitensteg 115-1, 115-2, 115-3 und die jeweilige dritte Stegaufnahme 109-1, 109-2, 109-3, nebeneinander in dem jeweiligen ersten, zweiten und dritten Tragelement 100-1, 100-2, 100-3 angeordnet.

Das erste, zweite und dritten Tragelement 100-1, 100-2 und 100-3 weist jeweils eine Tragelementbreite 117 auf. Die ersten, zweiten und dritten Stegaufnahme 105-1, 105-2, 105-3, 107-1, 107-2, 107-3, 109-1, 109-2, 109-3 sind als Vertiefungen ausgebildet, welche jeweils eine Vertiefungsbreite 119 aufweisen, wobei die Vertiefungsbreite 119 geringer als die Tragelementbreite 117 ist.

Die ersten Seitenstege 111-1, 111-2, 111-3 weisen jeweils eine Befestigungsöffnung 121 auf, und die ersten Stegaufnahmen 105-1, 105-2, 105-3 weisen jeweils eine weitere Befestigungsöffnung 123 auf. Die ersten Seitenstege 111-1, 111-2, 111-3 weisen eine erhöhte Oberfläche auf und die Befestigungsöffnungen 121 sind durch die ersten Seitenstege 111-1, 111-2, 111-3 geführt. Wenn die ersten Seitenstege 111-1, 111-2, 111-3 in die jeweiligen ersten Stegaufnahmen 105-1, 105-2, 105-3 eingeführt sind, sind die Befestigungsöffnungen 121 und die weiteren Befestigungsöffnungen 123 übereinander positioniert, und ermöglichen somit die Aufnahme jeweils eines Befestigungselements zur Befestigung des ersten, zweiten und dritten Tragelements 100-1, 100-2 und 100-3 miteinander. Das Befestigungselement kann eine Schraube umfassen, wobei die Befestigungsöffnungen 121 und die weiteren Befestigungsöffnungen 123 ein entsprechendes Gewinde umfassen können, um eine wirksame und stabile Befestigung sicherzustellen. An den jeweiligen Unterseiten der elektronischen Funktionsmodule kann ein Bolzen als ein Befestigungselement angebracht sein, wobei der Bolzen an den Befestigungsöffnungen 121 und den weiteren Befestigungsöffnungen 123 befestigt sein kann, um ein wirksames Befestigen der elektronischen Funktionsmodule an dem ersten, zweiten und dritten Tragelement 100-1, 100-2 und 100-3 zu ermöglichen.

Auch wenn dies in Fig. 1 nicht dargestellt ist, können die Befestigungsöffnungen 121 und die weiteren Befestigungsöffnungen 123 alternativ oder darüber hinaus an den zweiten Seitenstegen 113-1, 113-2, 113-3, 113-x und an den zweiten Stegaufnahmen 107-1, 107-2, 107-3, 107-x und/oder an den dritten Seitenstege 115-1, 115-2, 115-3, 115-x und an den dritten Stegaufnahmen 109-1, 109-2, 109-3, 109-x angeordnet sein.

Das erste, zweite und dritte Tragelement 100-1, 100-2 und 100-3 weist jeweils eine erste Kabelaufnahme 125-1, 125-2, 125-3 zur Aufnahme eines ersten elektrischen Kabels und weist jeweils eine zweite Kabelaufnahme 127-1, 127-2, 127-3 zur Aufnahme eines zweiten elektrischen Kabels auf. Wenn das erste, zweite und dritte Tragelement 100-1, 100-2 und 100-3 miteinander verbunden sind, ermöglichen die ersten Kabelaufnahmen 125-1, 125-2, 125-3, und die zweiten Kabelaufnahmen 127-1, 127-2, 127-3 eine durchgehende Aufnahme eines ersten und zweiten elektrischen Kabels an der Oberseite 101-1, 101-2 und 101-3 des ersten, zweiten und dritten Tragelements 100-1, 100-2 und 100-3.

Durch die in Fig. 1 dargestellte Ausgestaltung können die ersten, zweiten, dritten und weiteren Tragelemente 100-1, 100-2, 100-3 und 100-x vorteilhaft innerhalb eines modularen Aufbausystems eingesetzt werden. Durch die Aneinanderreihung des ersten, zweiten, dritten und weiteren Tragelements 100-1, 100-2, 100-3 und 100-x kann eine stabile Basis sichergestellt werden, auf die ein oder mehrere elektronische Funktionsmodule aufgesetzt werden können und gemeinsam einen festen mechanischen Verbund entstehen lassen, der wie ein einzelnes Gerät montiert werden kann. Zur Verbindung der einzelnen elektronischen Funktionsmodule kommt das erste und zweite elektrische Kabel zum Einsatz, welche insbesondere jeweils als ein Flachbandkabel ausgebildet sind. Damit sind die Anforderungen an die Schutzart sichergestellt und die elektrische Versorgung der elektronischen Funktionsmodule, sowie eine wirksame Kommunikation zwischen den einzelnen elektronischen Funktionsmodulen wird sichergestellt. Durch ein im System integriertes Gateway zur Integration des modularen Aufbausystems in unterschiedliche Kommunikationssysteme besteht die Möglichkeit dieses in unterschiedlichen Umfeldern einzusetzen.

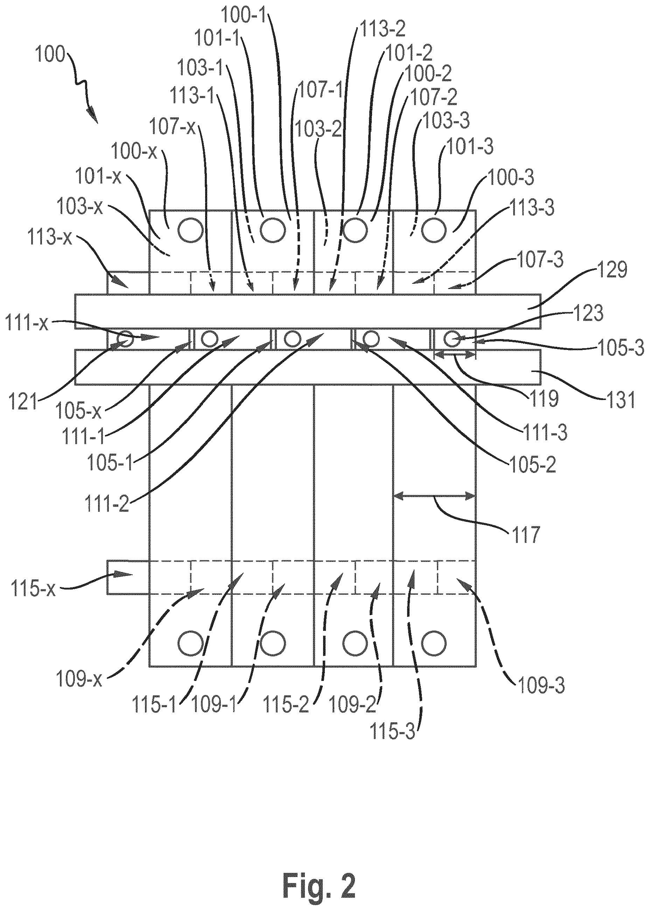

Fig. 2 zeigt eine schematische Ansicht einer Anordnung von Tragelementen mit elektrischen Kabeln gemäß einer zweiten Ausführungsform. Die Anordnung von Tragelementen 100 umfasst ein erstes, zweites, drittes und weiteres Tragelement 100-1, 100-2, 100-3, 100-x, welcher miteinander durch das Einführen von Seitenstegen 111-1, 111-2, 111-3, 111-x, 113-1, 113-2, 113-3, 113-x, 115-1, 115-2, 115-3, 115-x in entsprechende Stegaufnahmen 105-1, 105-2, 105-3, 105-x, 107-1, 107-2, 107-3, 107-x, 109-1, 109-2, 109-3, 109-x verbunden sind. Für eine detaillierte Beschreibung des ersten, zweiten, dritten und weiteren Tragelements 100-1, 100-2, 100-3, 100-x wird auf die erste Ausführungsform gemäß Fig. 1 verwiesen.

Die erste Kabelaufnahmen 125-1, 125-2, 125-3 und 125-x des ersten, zweiten, dritten und weiteren Tragelements 100-1, 100-2, 100-3 und 100-x sind in Fig. 2 nicht dargestellt, da in diesen jeweils ein erstes elektrisches Kabel 129 und ein zweites elektrisches Kabel 131 aufgenommen ist. Das erste und zweite elektrische Kabel 129, 131 ermöglichen eine elektrische Verbindung zwischen in Fig. 2 nicht dargestellten elektronischen Funktionskomponenten.

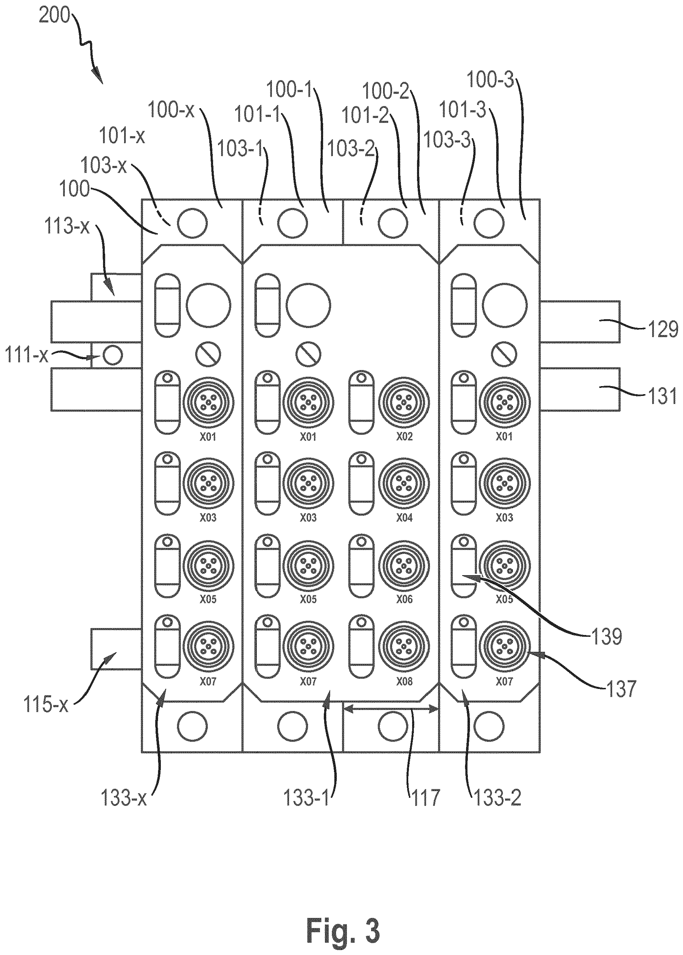

Fig. 3 zeigt eine schematische Ansicht eines elektronischen Komponentenaufbausystems mit einer Anordnung von Tragelementen, elektrischen Kabeln und einem elektronischen Funktionsmodul gemäß einer dritten Ausführungsform. Das elektronische Komponentenaufbausystem 200 umfasst ein erstes, zweites, drittes und weiteres Tragelement 100-1, 100-2, 100-3, 100-x, welcher miteinander durch das Einführen von Seitenstegen 111-1, 111-2, 111-3, 111-x, 113-1, 113-2, 113-3, 113-x, 115-1, 115-2, 115-3, 115-x in entsprechende Stegaufnahmen 105-1, 105-2, 105-3, 105-x, 107-1, 107-2, 107-3, 107-x, 109-1, 109-2, 109-3, 109-x verbunden sind. Für eine detaillierte Beschreibung des ersten, zweiten, dritten und weiteren Tragelements 100-1, 100-2, 100-3, 100-x wird auf die erste Ausführungsform gemäß Fig. 1 verwiesen. Einige Elemente des ersten, zweiten, dritten und weiteren Tragelements 100-1, 100-2, 100-3, 100-x sind in Fig. 3 nicht dargestellt.

Neben den Tragelementen 100-1, 100-2, 100-3, 100-x umfasst das elektronische Komponentenaufbausystem 200 ein erstes und zweites elektrisches Kabel 129, 131, sowie ein ersten, zweites und weiteres elektronischen Funktionsmodul 133-1, 133-2, 133-x. Hierbei ist das erste elektronische Funktionsmodul 133-1 etwa doppelt so breit wie die Tragelementbreite 117 und ist auf das erste und zweite Tragelement 100-1, 100-2 aufgesetzt. Das zweite elektronische Funktionsmodul 133-2 ist in der in Fig. 3 dargestellten Ansicht nur zur Hälfte dargestellt und ist auf das dritte Tragelement 100-3 aufgesetzt. Das weitere elektronische Funktionsmodul 133-x ist in der in Fig. 3 dargestellten Ansicht nur zur Hälfte dargestellt und ist auf das weitere Tragelement 100-x aufgesetzt. Die jeweiligen elektronischen Funktionsmodule 133-1, 133-2, 133-x weisen an der Unterseite ein in Fig. 3 nicht dargestelltes Befestigungselement 135 auf, um das jeweilige elektronische Funktionsmodul 133-1, 133-2, 133-x an den entsprechenden Tragelementen 100-1, 100-2, 100-3, 100-x zu fixieren.

Zwischen den Tragelementen 100-1, 100-2, 100-3, 100-x und den elektronischen Funktionsmodulen 133-1, 133-2, 133-x ist ein erstes und zweites elektrisches Kabel 129, 131 angeordnet, welche jeweils eine Isolationsschicht und eine elektrische Leiterbahn umfassen. Das jeweilige elektronische Funktionsmodul 133-1, 133-2, 133-x umfasst eine elektrisch leitfähige Dornanordnung zum Durchstechen der jeweiligen Isolationsschicht und zum elektrischen Kontaktieren der jeweiligen elektrischen Leiterbahn. Dadurch wird das jeweilige elektronische Funktionsmodul 133-1, 133-2, 133-x mit dem ersten elektrischen Kabel 129 und mit dem zweiten elektrischen Kabel 131 elektrisch leitend verbunden.

Das jeweilige elektronische Funktionsmodul 133-1, 133-2, 133-x weist eine Vielzahl von Steckverbindungen 137 auf, um die elektronischen Funktionsmodule 133-1, 133-2, 133-x mit anzuschließenden Geräten, beispielweise durch Kabelverbindungen, zu verbinden. Das jeweilige elektronische Funktionsmodul 133-1, 133-2, 133-x weist ferner eine Vielzahl von Beschriftungselementen 139, um die verschiedenen Steckverbindungen 137 zu markieren.

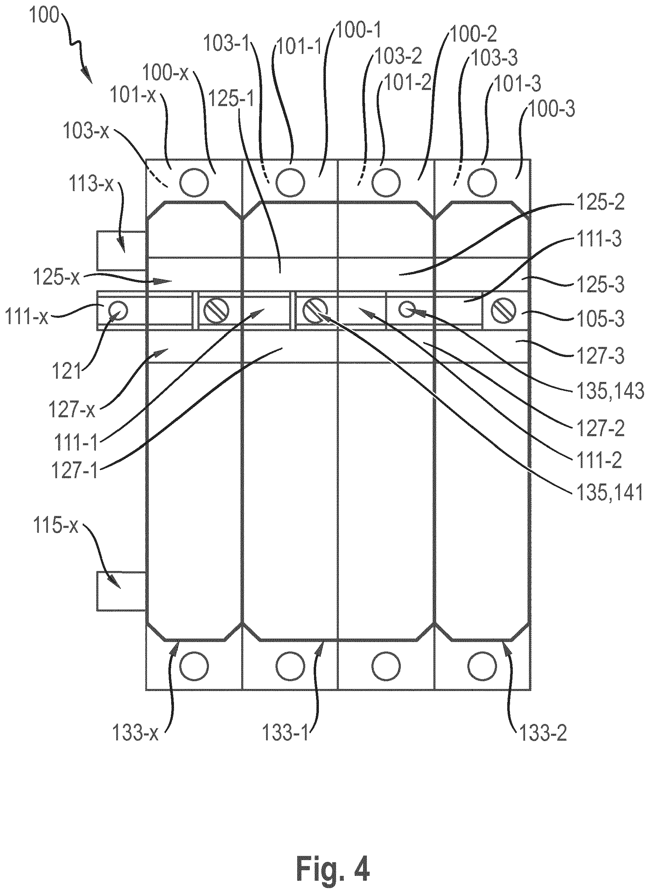

Fig. 4 zeigt eine schematische Ansicht eines elektronischen Komponentenaufbausystems gemäß der dritten Ausführungsform. In der Fig. 4 ist das erste und zweite elektrische Kabel 129, 131 nicht dargestellt und ist das jeweilige elektronische Funktionsmodul 133-1, 133-2, 133-x nur schematisch durch eine Umrandungslinie dargestellt. Für eine detaillierte Beschreibung des ersten, zweiten, dritten und weiteren Tragelements 100-1, 100-2, 100-3, 100-x wird auf die erste Ausführungsform gemäß Fig. 1 verwiesen. Einige Elemente des ersten, zweiten, dritten und weiteren Tragelements 100-1, 100-2, 100-3, 100-x sind in Fig. 4 nicht dargestellt.

Fig. 4 zeigt die Verbindung des ersten, zweiten, dritten und weiteren Tragelements 100-1, 100-2, 100-3, 100-x untereinander. Wenn die Tragelemente 100-1, 100-2, 100-3, 100-x verbunden sind, kann ein Befestigungselement 135, wie z.B. eine Schraube 141, durch die jeweilige Befestigungsöffnung 121 des jeweiligen Seitenstegs 111-1, 111-2, 111-3, 111-x, 113-1, 113-2, 113-3, 113-x, 115-1, 115-2, 115-3, 115-x und durch die jeweiligen weiteren Befestigungsöffnung 123 der jeweiligen Stegaufnahme 105-1, 105-2, 105-3, 105-x, 107-1, 107-2, 107-3, 107-x, 109-1, 109-2, 109-3, 109-x geführt werden, um die Tragelemente 100-1, 100-2, 100-3, 100-x untereinander zu verbinden. Somit ermöglicht das Befestigungselement 135 eine wirksame mechanische Verbindung zwischen den Tragelementen 100-1, 100-2, 100-3, 100-x.

Wie in Fig. 4 dargestellt ist, kann das Befestigungselement 135 anstatt einer Schraube 141 auch einen Bolzen 143 des ersten elektronischen Funktionsmoduls 133-1 umfassen. Der Bolzen 143 ist an einer Unterseite des ersten elektronischen Funktionsmoduls 133-1 ausgebildet und ermöglicht das erste elektronische Funktionsmodul 133-1 an dem zweiten Tragelement 100-2 zu befestigen. Die an der Unterseite des zweiten und weiteren elektronischen Funktionsmoduls 133-2, 133-x angeordnete Bolzen 143 sind in Fig. 4 nicht dargestellt.

Der Schutzumfang des Patents wird durch die Patentansprüche festgelegt.

### BEZUGSZEICHENLISTE

- 100: Anordnung von Tragelementen
- 100-1: Erstes Tragelement
- 100-2: Zweites Tragelement
- 100-3: Drittes Tragelement
- 100-x: Weiteres Tragelement
- 101-1: Oberseite des ersten Tragelements
- 101-2: Oberseite des zweiten Tragelements
- 101-3: Oberseite des dritten Tragelements
- 101-x: Oberseite des weiteren Tragelements
- 103-1: Unterseite des ersten Tragelements
- 103-2: Unterseite des zweiten Tragelements
- 103-3: Unterseite des dritten Tragelements
- 103-x: Unterseite des weiteren Tragelements
- 105-1: Erste Stegaufnahme des ersten Tragelements
- 105-2: Erste Stegaufnahme des zweiten Tragelements
- 105-3: Erste Stegaufnahme des dritten Tragelements
- 105-x: Erste Stegaufnahme eines weiteren Tragelements
- 107-1: Zweite Stegaufnahme des ersten Tragelements
- 107-2: Zweite Stegaufnahme des zweiten Tragelements
- 107-3: Zweite Stegaufnahme des dritten Tragelements
- 107-x: Zweite Stegaufnahme des weiteren Tragelements
- 109-1: Dritte Stegaufnahme des ersten Tragelements
- 109-2: Dritte Stegaufnahme des zweiten Tragelements
- 109-3: Dritte Stegaufnahme des dritten Tragelements
- 109-x: Dritte Stegaufnahme des weiteren Tragelements
- 111-1: Erster Seitensteg des ersten Tragelements
- 111-2: Erster Seitensteg des zweiten Tragelements
- 111-3: Erster Seitensteg des dritten Tragelements
- 111-x: Erster Seitensteg des weiteren Tragelements
- 113-1: Zweiter Seitensteg des ersten Tragelements
- 113-2: Zweiter Seitensteg des zweiten Tragelements
- 113-3: Zweiter Seitensteg des dritten Tragelements
- 113-x: Zweiter Seitensteg des weiteren Tragelements
- 115-1: Dritter Seitensteg des ersten Tragelements
- 115-2: Dritter Seitensteg des zweiten Tragelements
- 115-3: Dritter Seitensteg des dritten Tragelements
- 115-x: Dritter Seitensteg des weiteren Tragelements
- 117: Tragelementbreite
- 119: Vertiefungsbreite
- 121: Befestigungsöffnung
- 123: Weitere Befestigungsöffnung
- 125-1: Erste Kabelaufnahme des ersten Tragelements
- 125-2: Erste Kabelaufnahme des zweiten Tragelements
- 125-3: Erste Kabelaufnahme des dritten Tragelements
- 125-x: Erste Kabelaufnahme des weiteren Tragelements
- 127-1: Zweite Kabelaufnahme des ersten Tragelements
- 127-2: Zweite Kabelaufnahme des zweiten Tragelements
- 127-3: Zweite Kabelaufnahme des dritten Tragelements
- 127-x: Zweite Kabelaufnahme des weiteren Tragelements
- 129: Erstes elektrisches Kabel
- 131: Zweites elektrisches Kabel
- 133-1: Erstes elektronisches Funktionsmodul
- 133-2: Zweites elektronisches Funktionsmodul
- 133-x: Weiteres elektronisches Funktionsmodul
- 135: Befestigungselement
- 137: Steckverbindung
- 139: Beschriftungselement
- 141: Schraube
- 143: Bolzen
- 200: Komponentenaufbausystem

## Patentansprüche

1. Anordnung von Tragelementen (100) zur Halterung von elektronischen Funktionsmodulen (133-1, 133-2, 133-x), mit:
einem ersten Tragelement (100-1), wobei das erste Tragelement (100-1) eine Oberseite (101-1) und eine Unterseite (103-1) aufweist, wobei in der Oberseite (101-1) eine erste Stegaufnahme (105-1) gebildet ist, und wobei in der Unterseite (103-1) eine zweite Stegaufnahme (107-1) gebildet ist; und
einem zweiten Tragelement (100-2), wobei das zweite Tragelement (100-2) einen ersten Seitensteg (111-2) und einen zweiten Seitensteg (113-2) aufweist, wobei der erste Seitensteg (111-2) in die erste Stegaufnahme (105-1) einführbar ist, und wobei der zweite Seitensteg (113-2) in die zweite Stegaufnahme (107-1) einführbar ist,
wobei in einer Oberseite (101-1, 101-2, 101-3, 101-x) des ersten, zweiten, dritten oder weiteren Tragelements (100-1, 100-2, 100-3, 100-x) eine erste Kabelaufnahme (125-1, 125-2, 125-3, 125-x) zur Aufnahme eines ersten elektrischen Kabels (129) oder eine zweite Kabelaufnahme (127-1, 127-2, 127-3, 127-x) zur Aufnahme eines zweiten elektrischen Kabels (131) gebildet ist.

2. Anordnung nach Anspruch 1, wobei das erste Tragelement und das zweite Tragelement eine selbstragende Anordnung von Tragelementen, insbesondere eine selbsttragende und befestigbare Anordnung, bilden, und/oder wobei das erste Tragelement und das zweite Tragelement auf einer Tragschiene, insbesondere einer Hutschiene, verschiebbar befestigbar sind.

3. Anordnung von Tragelementen (100) nach Anspruch 1 oder 2, wobei das erste Tragelement (100-1) eine Tragelementbreite (117) aufweist, wobei die erste Stegaufnahme (105-1) und die zweite Stegaufnahme (107-1) als Vertiefungen mit einer Vertiefungsbreite (119) geformt sind, welche geringer als die Tragelementbreite (117) ist.

4. Anordnung von Tragelementen (100) nach einem der vorstehenden Ansprüche, wobei das zweite Tragelement (100-2) eine Oberseite (101-2) und eine Unterseite (103-2) aufweist, wobei der erste Seitensteg (111-2) in der Oberseite (101-2) des zweiten Tragelements (100-2) gebildet ist, und wobei der zweite Seitensteg (113-2) in der Unterseite (103-2) des zweiten Tragelements (100-2) gebildet ist.

5. Anordnung von Tragelementen (100) nach einem der vorstehenden Ansprüche, wobei in der Oberseite (101-1) des ersten Tragelements (100-1) ein erster Seitensteg (111-1) gebildet ist, welcher in eine erste Stegaufnahme (105-x) eines weiteren Tragelements (100-x) einführbar ist, und wobei in der Unterseite (103-1) des ersten Tragelements (100-1) ein zweiter Seitensteg (113-1) gebildet ist, welcher in eine zweite Stegaufnahme (107-x) des weiteren Tragelements (100-x) einführbar ist.

6. Anordnung von Tragelementen (100) nach einem der vorstehenden Ansprüche, wobei in einer Oberseite (101-2) des zweiten Tragelements (100-2) eine erste Stegaufnahme (105-2) zur Aufnahme eines ersten Seitenstegs (111-3) eines dritten Tragelements (100-3) gebildet ist, und wobei in einer Unterseite (103-2) des zweiten Tragelements (100-1) eine zweite Stegaufnahme (107-2) zur Aufnahme eines zweiten Seitenstegs (113-3) des dritten Tragelements (100-3) gebildet ist.

7. Anordnung von Tragelementen (100) nach einem der vorstehenden Ansprüche, wobei in einer Unterseite (103-1, 103-2, 103-3, 103-x) des ersten, zweiten, dritten oder weiteren Tragelements (100-1, 100-2, 100-3, 100-x) jeweils eine dritte Stegaufnahme (109-1, 109-2, 109-3, 109-x) gebildet ist, wobei das erste, zweite oder dritte Tragelement (100-1, 100-2, 100-3) jeweils einen dritten Seitensteg (115-1, 115-2, 115-3) aufweist, und wobei der dritte Seitensteg (115-1) des ersten Tragelements (100-1) in die dritte Stegaufnahme (109-x) des weiteren Tragelements (100-x) einführbar ist, wobei der dritte Seitensteg (115-2) des zweiten Tragelements (100-2) in die dritte Stegaufnahme (109-1) des ersten Tragelements (100-1) einführbar ist, oder wobei der dritte Seitensteg (115-3) des dritten Tragelements (100-3) in die dritte Stegaufnahme (109-2) des zweiten Tragelements (100-2) einführbar ist.

8. Anordnung von Tragelementen (100) nach einem der vorstehenden Ansprüche, wobei der erste Seitensteg (111-1, 111-2, 111-3) und die erste Stegaufnahme (105-1, 105-2, 105-3), der zweite Seitensteg (113-1, 113-2, 113-3) und die zweite Stegaufnahme (107-1, 107-2, 107-3), oder der dritte Seitensteg (115-1, 115-2, 115-3) und die dritte Stegaufnahme (109-1, 109-2, 109-3) nebeneinander in dem ersten, zweiten oder dritten Tragelement (100-1, 100-2, 100-3) angeordnet sind.

9. Anordnung von Tragelementen (100) nach einem der vorstehenden Ansprüche, wobei der erste, zweite oder dritte Seitensteg (111-1, 111-2, 111-3, 113-1, 113-2, 113-3, 115-1, 115-2, 115-3) jeweils durch eine Rastverbindung in der jeweiligen ersten, zweiten oder dritten Stegaufnahme (105-1, 105-2, 105-3, 105-x, 107-1, 107-2, 107-3, 107-x, 109-1, 109-2, 109-3, 109-x) befestigbar ist.

10. Anordnung von Tragelementen (100) nach einem der vorstehenden Ansprüche, wobei der erste, zweite oder dritte Seitensteg (111-1, 111-2, 111-3, 113-1, 113-2, 113-3, 115-1, 115-2, 115-3) jeweils eine Befestigungsöffnung (121) zur Aufnahme eines Befestigungselements (135) aufweisen, wobei die erste, zweite oder dritte Stegaufnahme (105-1, 105-2, 105-3, 107-1, 107-2, 107-3, 109-1, 109-2, 109-3) jeweils eine weitere Befestigungsöffnung (123) zur Aufnahme des Befestigungselements (135) aufweisen.

11. Anordnung von Tragelementen (100) nach Anspruch 10, wobei das Befestigungselement (135) eine Schraube (141) zum Verbinden des ersten, zweiten, dritten oder weiteren Tragelements (100-1, 100-2, 100-3, 100-x) miteinander umfasst, oder einen Bolzen (143) eines elektronischen Funktionsmoduls (133-1, 133-2, 133-x) zum Befestigen des elektronischen Funktionsmoduls (133-1, 133-2, 133-x) an dem ersten, zweiten, dritten oder weiteren Tragelement (100-1, 100-2, 100-3, 100-x) umfasst.

12. Komponentenaufbausystem (200), mit:
einer Anordnung (100) aus zumindest einem ersten und zweiten Tragelement (100-1, 100-2), wobei das erste Tragelement (100-1) eine Oberseite (101-1) und eine Unterseite (103-1) aufweist, wobei in der Oberseite (101-1) eine erste Stegaufnahme (105-1) gebildet ist, und wobei in der Unterseite (103-1) eine zweite Stegaufnahme (107-1) gebildet ist; und wobei das zweite Tragelement (100-2) einen ersten Seitensteg (111-2) und einen zweiten Seitensteg (113-2) aufweist, wobei der erste Seitensteg (111-2) in die erste Stegaufnahme (105-1) einführbar ist, und wobei der zweite Seitensteg (113-2) in die zweite Stegaufnahme (107-1) einführbar ist,
einem ersten elektrischen Kabel (129), welches in einer ersten Kabelaufnahme (125-1, 125-2) an einer Oberseite (101-1, 101-2) des zumindest einen ersten und zweiten Tragelements (100-1, 100-2) aufgenommen ist;
einem zweiten elektrischen Kabel (131), welches in einer zweiten Kabelaufnahme (127-1, 127-2) an einer Oberseite (101-1, 101-2) des zumindest einen ersten und zweiten Tragelements (100-1, 100-2) aufgenommen ist; und
zumindest einem ersten elektronischen Funktionsmodul (133-1) zum Aufsetzen auf das erste und zweite Tragelement (100-1, 100-2), wobei das erste elektronische Funktionsmodul (133-1) mit dem ersten elektrischen Kabel (129) und mit dem zweiten elektrischen Kabel (131) elektrisch leitend verbunden ist.

13. Komponentenaufbausystem (200) nach Anspruch 12, wobei das erste elektronische Funktionsmodul (133-1) an einer Unterseite ein Befestigungselement (135) aufweist, um das erste elektronische Funktionsmodul (133-1) an dem ersten und zweiten Tragelement (100-1, 100-2) zu befestigen.

14. Komponentenaufbausystem (200) nach Anspruch 12 oder 13, wobei das erste und zweite elektrische Kabel (129, 131) jeweils eine Isolationsschicht und zumindest eine elektrische Leiterbahn umfassen, wobei das erste elektronische Funktionsmodul (133-1) eine elektrisch leitfähige Dornanordnung zum Durchstechen der jeweiligen Isolationsschicht und zum elektrischen Kontaktieren der jeweiligen elektrischen Leiterbahn umfasst.

## Claims

1. Arrangement of support elements (100) for holding electronic functional modules (133-1, 133-2, 133-x), comprising:
a first support element (100-1), wherein the first support element (100-1) has an upper side (101-1) and a lower side (103-1), wherein a first bridge receptacle (105-1) is formed in the upper side (101-1), and wherein a second bridge receptacle (107-1) is formed in the lower side (103-1); and
a second support element (100-2), wherein the second support element (100-2) has a first side bridge (111-2) and a second side bridge (113-2), wherein the first side bridge (111-2) is insertable in the first bridge receptacle (105-1), and wherein the second side bridge (113-2) is insertable in the second bridge receptacle (107-1),
wherein in an upper side (101-1, 101-2, 101-3, 101 -x) of the first, second, third or further support element (100-1, 100-2, 100-3, 100-x) a first cable receptacle (125-1, 125-2, 125-3, 125-x) for receiving a first electrical cable (129) or a second cable receptacle (127-1, 127-2, 127-3, 127-x) for receiving a second electrical cable (131) is formed.

2. Arrangement according to claim 1, wherein the first support element and the second support element form a self-supporting arrangement of support elements, in particular a self-supporting and attachable arrangement, and/or wherein the first support element and the second support element are slidably fastened on a support rail, in particular a top-hat rail.

3. Arrangement of support elements (100) according to claim 1 or 2, wherein the first support element (100-1) has a support element width (117), wherein the first bridge receptacle (105-1) and the second bridge receptacle (107-1) are formed as recesses with a recess width (119) that is smaller than the support element width (117).

4. Arrangement of support elements (100) according to one of the preceding claims, wherein the second support element (100-2) has an upper side (101-2) and a lower side (103-2), wherein the first side bridge (111-2) is formed in the upper side (101-2) of the second support element (100-2), and wherein the second side bridge (113-2) is formed in the lower side (103-2) of the second support element (100-2).

5. Arrangement of support elements (100) according to one of the preceding claims, wherein in the upper side (101-1) of the first support element (100-1) a first side bridge (111-1) is formed, which is insertable into a first bridge receptacle (105-x) of a further support element (100-x), and wherein in the lower side (103-1) of the first support element (100-1) a second side bridge (113-1) is formed, which is insertable into a second bridge receptacle (107-x) of the further support element (100-x).

6. Arrangement of support elements (100) according to one of the preceding claims, wherein a first bridge receptacle (105-2) is formed in an upper side (101-2) of the second support element (100-2) to receive a first side bridge (111-3) of a third bridge support (100-3), and wherein a second bridge receptacle (107-2) is formed in a lower side (103-2) of the second support element (100-1) to receive a second side bridge (113-3) of the third support element (100-3).

7. Arrangement of support elements (100) according to one of the preceding claims, wherein a third bridge receptacle (109-1, 109-2, 109-3, 109-x) is respectively formed in a lower side (103-1, 103-2, 103-3, 103-x) of the first, second, third or further support element (100-1, 100-2, 100-3, 100-x), wherein the first, second or third support element (100-1, 100-2, 100-3) respectively has a third side bridge (115-1, 115-2, 115-3), and wherein the third side bridge (115-1) of the first support element (100-1) is insertable in the third bridge receptacle (109-x) of the further support element (100-x), wherein the third side bridge (115-2) of the second support element (100-2) is insertable in the third bridge receptacle (109-1) of the first support element (100-1), or wherein the third side bridge (115-3) of the third support element (100-3) is insertable in the third bridge receptacle (109-2) of the second support element (100-2).

8. Arrangement of support elements (100) according to one of the preceding claims, wherein the first side bridge (111-1, 111-2, 111-3) and the first bridge receptacle (105-1, 105-2, 105-3), the second side bridge (113-1, 113-2, 113-3) and the second bridge receptacle (107-1, 107-2, 107-3), or the third side bridge (115-1, 115-2, 115-3) and the third bridge receptacle (109-1, 109-2, 109-3) are arranged side by side in the first, second or third support element (100-1, 100-2, 100-3).

9. Arrangement of support elements (100) according to one of the preceding claims, wherein the first, second or third side bridge (111-1, 111-2, 111-3, 113-1, 113-2, 113-3, 115-1, 115-2, 115-3) is respectively fastenable in the respective first, second or third bridge receptacle (105-1, 105-2, 105-3, 105-x, 107-1, 107-2, 107-3, 107-x, 109-1, 109-2, 109-3, 109-x) by a latching connection.

10. Arrangement of support elements (100) according to any one of the preceding claims, wherein the first, second or third side bridge (111-1, 111-2, 111-3, 113-1, 113-2, 113-3, 115-1, 115-2, 115-3) respectively comprises a mounting hole (121) to receive a fastening element (135), wherein the first, second or third bridge receptacle (105-1, 105-2, 105-3, 107-1, 107-2, 107-3, 109-1, 109-2, 109-3) respectively comprises a further mounting hole (123) for receiving the fastening element (135).

11. Arrangement of support elements (100) according to claim 10, wherein the fastening element (135) comprises a screw (141) for connecting together the first, second, third or further support element (100-1, 100-2, 100-3, 100-x) or a bolt (143) of an electronic functional module (133-1, 133-2, 133-x) for fixing the electronic functional module (133-1, 133-2, 133-x) to the first, second, third or further support element (100-1, 100-2, 100-3, 100-x).

12. Component assembly system (200), comprising:
an arrangement (100) comprising at least a first and second support element (100-1, 100-2), wherein the first support element (100-1) has an upper side (101-1) and a lower side (103-1), wherein a first bridge receptacle (105-1) is formed in the upper side (101-1), and wherein a second bridge receptacle (107-1) is formed in the lower side (103-1); and wherein the second support element (100-2) has a first side bridge (111-2) and a second side bridge (113-2), wherein the first side bridge (111-2) is insertable in the first bridge receptacle (105-1), and wherein the second side bridge (113-2) is insertable in the second bridge receptacle (107-1),
a first electrical cable (129), which is received in a first cable receptacle (125-1, 125-2) at an upper side (101-1, 101-2) of the at least one first and second support element (100-1, 100-2);
a second electrical cable (131), which is received in a second cable receptacle (127-1, 127-2) at an upper side (101-1, 101-2) of the at least one first and second support element (100-1, 100-2); and
at least a first electronic functional module (133-1) for mounting on the first and second support element (100-1, 100-2), wherein the first electronic functional module (133-1) is electrically connected with the first electrical cable (129) and with the second electrical cable (131).

13. Component assembly system (200) according to claim 12, wherein the first electronic functional module (133-1) has a fastening element (135) at a lower side to attach the first electronic function module (133-1) to the first and second support element (100-1, 100-2).

14. Component assembly system (200) according to claim 12 or 13, wherein the first and second electrical cable (129, 131) respectively comprises an insulation layer and at least one electrical conducting path, wherein the first electronic functional module (133-1) comprises an electrically conductive mandrel arrangement for piercing the respective insulation layer and for electrically contacting the respective electrical conducting path.

## Revendications

1. Agencement d'éléments supports (100) pour le maintien de modules fonctionnels électroniques (133-1, 133-2, 133-x), comprenant :
un premier élément support (100-1), dans lequel le premier élément support (100-1) présente un côté supérieur (101-1) et un côté inférieur (103-1), dans lequel un premier logement de traverse (105-1) est formé dans le côté supérieur (101-1), et dans lequel un deuxième logement de traverse (107-1) est formé dans le côté inférieur (103-1) ; et
un deuxième élément support (100-2), dans lequel le deuxième élément support (100-2) présente une première traverse latérale (111-2) et une deuxième traverse latérale (113-2), dans lequel la première traverse latérale (111-2) peut être insérée dans le premier logement de traverse (105-1), et dans lequel la deuxième traverse latérale (113-2) peut être insérée dans le deuxième logement de traverse (107-1),
dans lequel un premier logement de câble (125-1, 125-2, 125-3, 125-x) pour loger un premier câble électrique (129) ou un deuxième logement de câble (127-1, 127-2, 127-3, 127-x) pour loger un deuxième câble électrique (131) est formé dans un côté supérieur (101-1, 101-2, 101-3, 101-x) du premier, du deuxième, du troisième ou d'un autre élément support (100-1, 100-2, 100-3, 100-x).

2. Agencement selon la revendication 1, dans lequel le premier élément support et le deuxième élément support forment un agencement autoportant d'éléments supports, notamment un agencement autoportant et fixable, et/ou dans lequel le premier élément support et le deuxième élément support peuvent être fixés de manière coulissante sur un rail support, notamment un rail chapeau.

3. Agencement d'éléments supports (100) selon la revendication 1 ou 2, dans lequel le premier élément support (100-1) présente une largeur d'élément support (117), dans lequel le premier logement de traverse (105-1) et le deuxième logement de traverse (107-1) sont formés sous forme de creux avec une largeur de creux (119) qui est inférieure à la largeur d'élément support (117) .

4. Agencement d'éléments supports (100) selon l'une quelconque des revendications précédentes, dans lequel le deuxième élément support (100-2) présente un côté supérieur (101-2) et un côté inférieur (103-2), dans lequel la première traverse latérale (111-2) est formée dans le côté supérieur (101-2) du deuxième élément support (100-2), et dans lequel la deuxième traverse latérale (113-2) est formée dans le côté inférieur (103-2) du deuxième élément support (100-2).

5. Agencement d'éléments supports (100) selon l'une quelconque des revendications précédentes, dans lequel une première traverse latérale (111-1) est formée dans le côté supérieur (101-1) du premier élément support (100-1), laquelle peut être insérée dans un premier logement de traverse (105-x) d'un autre élément support (100-x), et dans lequel une deuxième traverse latérale (113-1) est formée dans le côté inférieur (103-1) du premier élément support (100-1), laquelle peut être insérée dans un deuxième logement de traverse (107-x) de l'autre élément support (100-x).

6. Agencement d'éléments supports (100) selon l'une quelconque des revendications précédentes, dans lequel un premier logement de traverse (105-2) pour loger une première traverse latérale (111-3) d'un troisième élément support (100-3) est formé dans un côté supérieur (101-2) du deuxième élément support (100-2), et dans lequel un deuxième logement de traverse (107-2) pour loger une deuxième traverse latérale (113-3) du troisième élément support (100-3) est formé dans un côté inférieur (103-2) du deuxième élément support (100-1).

7. Agencement d'éléments supports (100) selon l'une quelconque des revendications précédentes, dans lequel un troisième logement de traverse (109-1, 109-2, 109-3, 109-x) est formé respectivement dans un côté inférieur (103-1, 103-2, 103-3, 103-x) du premier, du deuxième, du troisième ou d'un autre élément support (100-1, 100-2, 100-3, 100-x), dans lequel le premier, le deuxième ou le troisième élément support (100-1, 100-2, 100-3) présentent respectivement une troisième traverse latérale (115-1, 115-2, 115-3), et dans lequel la troisième traverse latérale (115-1) du premier élément support (100-1) peut être insérée dans le troisième logement de traverse (109-x) de l'autre élément support (100-x), dans lequel la troisième traverse latérale (115-2) du deuxième élément support (100-2) peut être insérée dans le troisième logement de traverse (109-1) du premier élément support (100-1), ou dans lequel la troisième traverse latérale (115-3) du troisième élément support (100-3) peut être insérée dans le troisième logement de traverse (109-2) du deuxième élément support (100-2).

8. Agencement d'éléments supports (100) selon l'une quelconque des revendications précédentes, dans lequel la première traverse latérale (111-1, 111-2, 111-3) et le premier logement de traverse (105-1, 105-2, 105-3), la deuxième traverse latérale (113-1, 113-2, 113-3) et le deuxième logement de traverse (107-1, 107-2, 107-3), ou la troisième traverse latérale (115-1, 115-2, 115-3) et le troisième logement de traverse (109-1, 109-2, 109-3) sont agencés côte à côte dans le premier, le deuxième ou le troisième élément support (100-1, 100-2, 100-3).

9. Agencement d'éléments supports (100) selon l'une des revendications précédentes, dans lequel la première, la deuxième ou la troisième traverse latérale (111-1, 111-2, 111-3, 113-1, 113-2, 113-3, 115-1, 115-2, 115-3) peut être fixée respectivement par une liaison par encliquetage dans le premier, le deuxième ou le troisième logement de traverse respectif (105-1, 105-2, 105-3, 105-x, 107-1, 107-2, 107-3, 107-x, 109- 1, 109-2, 109-3, 109-x) .

10. Agencement d'éléments supports (100) selon l'une quelconque des revendications précédentes, dans lequel la première, la deuxième ou la troisième traverse latérale (111-1, 111-2, 111-3, 113-1, 113-2, 113-3, 115-1, 115-2, 115-3) présente respectivement une ouverture de fixation (121) pour loger un élément de fixation (135), dans lequel le premier, le deuxième ou le troisième logement de traverse (105-1, 105-2, 105-3, 107-1, 107-2, 107-3, 109-1, 109-2, 109-3) présente respectivement une autre ouverture de fixation (123) pour loger l'élément de fixation (135).

11. Agencement d'éléments supports (100) selon la revendication 10, dans lequel l'élément de fixation (135) comprend une vis (141) pour relier le premier, le deuxième, le troisième ou un autre élément support (100-1, 100-2, 100-3, 100-x) entre eux, ou comprend un boulon (143) d'un module fonctionnel électronique (133-1, 133-2, 133-x) pour fixer le module fonctionnel électronique (133-1, 133-2, 133-x) au premier, au deuxième, au troisième ou à un autre élément support (100-1, 100-2, 100-3, 100-x).

12. Système d'assemblage de composants (200), comprenant :
un agencement (100) d'au moins un premier et un deuxième élément support (100-1, 100-2), dans lequel le premier élément support (100-1) présente un côté supérieur (101-1) et un côté inférieur (103-1), dans lequel un premier logement de traverse (105-1) est formé dans le côté supérieur (101-1), et un deuxième logement de traverse (107-1) est formé dans le côté inférieur (103-1) ; et dans lequel le deuxième élément support (100-2) présente une première traverse latérale (111-2) et une deuxième traverse latérale (113-2), la première traverse latérale (111-2) pouvant être insérée dans le premier logement de traverse (105-1), et la deuxième traverse latérale (113-2) pouvant être insérée dans le deuxième logement de traverse (107-1),
un premier câble électrique (129) qui est logé dans un premier logement de câble (125-1, 125-2) sur un côté supérieur (101-1, 101-2) de l'au moins un premier et un deuxième élément support (100-1, 100-2) ;
un deuxième câble électrique (131) qui est logé dans un deuxième logement de câble (127-1, 127-2) sur un côté supérieur (101-1, 101-2) de l'au moins un premier et un deuxième élément support (100-1, 100-2) ; et
au moins un premier module fonctionnel électronique (133-1) destiné à être placé sur le premier et le deuxième élément support (100-1, 100-2), le premier module fonctionnel électronique (133-1) étant relié de manière électriquement conductrice au premier câble électrique (129) et au deuxième câble électrique (131).

13. Système d'assemblage de composants (200) selon la revendication 12, dans lequel le premier module fonctionnel électronique (133-1) présente un élément de fixation (135) sur un côté inférieur afin de fixer le premier module fonctionnel électronique (133-1) au premier et au deuxième élément support (100-1, 100-2).

14. Système d'assemblage de composants (200) selon la revendication 12 ou 13, dans lequel le premier et le deuxième câble électrique (129, 131) comprennent respectivement une couche isolante et au moins une piste conductrice électrique, dans lequel le premier module fonctionnel électronique (133-1) comprend un agencement de mandrin électriquement conducteur pour percer la couche isolante respective et pour établir un contact électrique avec la piste conductrice électrique respective.
